# EUROPÄISCHE PATENTSCHRIFT

(11) **EP 3 724 937 B1**
(45) Veröffentlichungstag und Bekanntmachung des Hinweises auf die Patenterteilung: **06.05.2026**
(21) Anmeldenummer: 18819086.2
(22) Anmeldetag: 11.12.2018
(51) Int. Cl.: H10K 59/12, H10K 59/80, H10K 59/131, H10K 59/121, H10K 71/80

(54) **VERFAHREN ZUM HERSTELLEN EINES SEMITRANSPARENTEN DISPLAYS SOWIE EIN SEMITRANSPARENTES DISPLAY**
METHOD FOR PRODUCING A SEMI-TRANSPARENT DISPLAY AND A SEMI-TRANSPARENT DISPLAY
PROCÉDÉ DE FABRICATION D'UN ÉCRAN SEMI-TRANSPARENT ET ÉCRAN SEMI-TRANSPARENT

(30) Priorität: 12.12.2017 DE 102017129524
(43) Veröffentlichungstag der Anmeldung: 21.10.2020
(73) Patentinhaber: Fraunhofer-Gesellschaft zur Förderung der angewandten Forschung e.V., 80686 München (DE)
(72) Erfinder: RICHTER, Bernd, 01159 Dresden (DE); WARTENBERG, Philipp, 01097 Dresden (DE); BRENNER, Stephan, 01277 Dresden (DE); KIRCHHOFF, Volker, 01829 Wehlen (DE); VOGEL, Uwe, 01324 Dresden (DE)
(74) Vertreter: Pfitzner, Hannes
(86) Internationale Anmeldenummer: PCT/EP2018/084349
(87) Internationale Veröffentlichungsnummer: WO 2019/115518

(56) Entgegenhaltungen:
- EP-A2- 1 480 272
- WO-A1-2013/062707
- US-A1- 2010 045 919
- US-A1- 2015 250 038
- US-A1- 2015 309 637

## Beschreibung

Die Erfindung betrifft ein Verfahren zum Herstellen eines semitransparenten Displays. Unter einem semitransparenten Display im Erfindungssinn ist ein Display zu verstehen, welches eine Vielzahl von ersten Oberflächenbereichen umfasst, innerhalb denen Licht, welches mit einem menschlichen Auge erfassbar ist, von beiden Seiten des Displays durch das Display hindurchstrahlen kann. Des Weiteren umfasst ein semitransparentes Display eine Vielzahl von zweiten Oberflächenbereichen, innerhalb denen Licht, welches mit einem menschlichen Auge erfassbar ist, nicht durch das Display hindurchstrahlen kann.

Displays erlangen eine zunehmende Bedeutung für das Darstellen von Informationen. Sollen derartige Informationen beispielsweise beim Tragen von Brillen oder beim Benutzen von Ferngläsern in den Sichtbereich einer Person eingeblendet werden, sind transparente bzw. semitransparente Displays von Vorteil.

Aus US 2015/0250038 A1 und US 2015/0309637 A1 sind Verfahren zum Herstellen eines Displays bekannt, bei welchen zu Beginn der Schichtabscheidung temporär ein erstes Substrat verwendet wird, welches während der ersten Schichtabscheideprozesse eine hierfür erforderliche mechanische Stabilität gewährleistet. Auf dieses Substrat werden Dünnfilmtransistoren, Elektroden und Verdrahtungsebenen aufgetragen und strukturiert. Im Laufe des Displayaufbaus wird das erste Substrat vom Schichtstapel abgelöst und durch ein zweites, meist flexibleres Substrat ersetzt. Wegen des erneuten Hinzufügens eines Substrates kann das Ansteuern der Displaypixel ausschließlich über die Dünnfilmtransistoren oberhalb des Substrates erfolgen, weshalb eine Miniaturisierung der Displaypixel auch durch die Dünnfilmtransistoren limitiert wird. Derartige Verfahren sind nicht zum Herstellen von Mikrodisplays geeignet, bei welchen üblicherweise Pixelgrößen im Bereich von 1 - 10 µm erforderlich sind. Der Austausch des Substrates erfordert außerdem einen zusätzlichen Aufwand, der die Herstellungskosten erhöht.

OLED-Displays und Verfahren zum Herstellen von OLED-Displays, bei welchen die Schaltelemente zum Ansteuern der Displaypixel auf der sogenannten TFT-Technologie beruhen, sind zum Beispiel in US 2010/0045919 A1 und EP 1 480 272 A2 beschrieben. Die aktive Schicht von TFT-Transistoren wird oberhalb eines Substrates aus amorphen oder polykristallinen Halbleitern ausgebildet. Derartige Halbleiter weisen eine geringe Mobilität der Ladungsträger auf und in der Regel ist entweder ein Elektronen-leitender Transistor (NMOS) oder ein Loch-leitender Transistor (PMOS) im TFT-Prozess verfügbar. Hierdurch ist das Realisieren komplexer Schaltungen sehr stark eingeschränkt. Darüber hinaus sind die Strukturierungsverfahren für TFT-Transistoren limitiert und erlauben in der Regel minimale Kanallängen im Bereich von 3 - 5 µm. Daher ist es auch mittels der TFT-Technologie nicht möglich, Mikrodisplays mit Pixelgrößen im Bereich von 1 - 10 µm auszubilden.

WO 2013/062707 A1 offenbart ebenfalls OLED-Displays und Verfahren zum Herstellen von OLED-Displays, bei welchen das Display in ein starres Gehäuse eingebettet ist, was die Anwendung derartiger Displays begrenzt. Hierbei wird das Display aus unterschiedlichen Teilkomponenten zu einem Gesamtsystem zusammengefügt. Der zusammengesetzte Aufbau und die hierfür notwendig Aufbau-und Verbindungstechnik limitieren das Miniaturisieren eines solchen Displays, wobei ebenfalls kein für Mikrodisplays erforderlichen Pixelgrößen im Bereich von 1 - 10 µm realisierbar sind.

Als Basis zum Herstellen eines Displays wird oftmals ein aus dem Stand der Technik bekannter Wafer verwendet, bei welchem auf einem Siliziumsubstrat eine Schicht aus einem elektrisch nicht leitendem Material abgeschieden ist. Dabei verleiht das Siliziumsubstrat dem Wafer seine mechanische Stabilität und stellt für nachfolgende veranschaulichende Beschreibungen die Rückseite eines solchen Wafers dar. Die Schicht aus elektrisch nicht leitendem Material weist wiederum eine Vielzahl nebeneinander angeordnete siliziumbasierte Aktivgebiete auf, innerhalb denen Transistoren bzw. elektrische Schaltungen ausgebildet sind. Diese Transistoren bzw. elektrische Schaltungen können zum Ansteuern der einzelnen Pixel des Displays verwendet werden. Aufgrund des Anordnens von siliziumbasierten Aktivgebieten auf oder innerhalb einer Isolatorschicht werden eine solche Technologie und ein solcher Wafer auch mit dem englischen Fachbegriff "Silizium-On-Insulator" oder verkürzt "SOI" verknüpft. Ein SOl-Wafer weist ferner auch noch mindestens eine oberhalb der Aktivgebiete angeordnete Schicht auf, die meist aus einem transparenten Oxid besteht, innerhalb der elektrisch leitfähige Verbindungen zwischen den Anschlüssen der elektrischen Schaltungen aus den siliziumbasierten Aktivgebieten ausgebildet sind. Oftmals sind auch bei einem SOI-Wafer mehrere solcher Oxidschichten übereinander abgeschieden, innerhalb denen dann mehrere Verdrahtungsebenen übereinander ausgebildet sind.

Bezogen auf die Oberfläche eines SOI-Wafers, der zum Herstellen eines Displays verwendet wird, teilt sich diese meistens in mindestens einen Pixelbereich und mindestens einen Kontaktbereich auf, wobei nachfolgend innerhalb des Pixelbereichs das bilddarstellende Display und innerhalb des Kontaktbereiches elektrisch leitfähige Verbindungen zu externen Bauelementen ausgebildet werden. Schon wegen des Silizium-Substrates sind SOl-Wafer üblicherweise nichttransparent bezüglich Licht, welches mit einem menschlichen Auge erfasst werden kann.

In US 005317236 A sind Verfahren zum Herstellen eines semitransparenten LCD-Displays beschrieben, bei welchen SOl-Wafer als Basis für den Displayaufbau verwendet werden, auf welche eine elektrolumineszierende Schicht und eine Gegenelektrodenschicht abgeschieden werden. Um eine Transparenz des Displays zu erlangen wird vorgeschlagen, das Silizium-Substrat des SOI-Wafers zu entfernen und durch ein transparentes Substrat wie beispielsweise Glas zu ersetzen. Nachteilig wirkt sich hierbei aus, dass elektrisch leitfähige Verbindungen vom Kontaktbereich des SOI-Wafers zu anderen Bauteilen, wie beispielsweise einen Verdrahtungsträger, nur von der Vorderseite des SOI-Wafers hergestellt werden können, was deren Einsatzmöglichkeiten einschränkt.

Der Erfindung liegt daher das technische Problem zugrunde, ein Verfahren zum Herstellen eines semitransparenten Displays zu schaffen, mittels dessen die Nachteile aus dem Stand der Technik überwunden werden können. Insbesondere soll es mit dem erfindungsgemäßen Verfahren auch möglich sein, rückseitige Kontaktierungsmöglichkeiten zu anderen Bauelementen auszubilden.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Beim erfindungsgemäßen Verfahren wird auf einem aus dem Stand der Technik bekannten SOl-Wafer mindestens eine elektromagnetische Strahlung emittierenden Schicht auf der Vorderseite des SOI-Wafers abgeschieden. Diese mindestens eine elektromagnetische Strahlung emittierende Schicht ist vorzugsweise als organische Schicht ausgebildet, kann alternativ aber auch eine anorganische Schicht sein. Damit bei einem Display die elektromagnetische Strahlung emittierende Schicht auch elektromagnetische Strahlung emittieren kann, sind an die Schicht angrenzende Pixelelektroden und an die Schicht angrenzende Pixelgenelektroden erforderlich.

Bei einer Ausführungsform der Erfindung werden die Pixelelektroden und Pixelgegenelektroden für die mindestens eine elektromagnetische Strahlung emittierende Schicht innerhalb einer Ebene angeordnet und als Bestandteil des SOI-Wafers ausgebildet.

Alternativ können auch nur die Pixelelektroden als Bestandteil des SOI-Wafers ausgebildet werden, wobei dann zusätzlich auch noch eine elektrisch leitfähige Schicht oberhalb angrenzend an die mindestens eine elektromagnetische Strahlung emittierende Schicht abgeschieden wird, welche als Gegenelektrode fungiert. Diese elektrisch leitfähige Schicht kann alternativ auch als Teilschicht ausgebildet und oberer Bestandteil der mindestens einen elektromagnetische Strahlung emittierenden Schicht sein. Bei einer weiteren Ausführungsform wird die elektrisch leitfähige Schicht bzw. elektrisch leitfähige Teilschicht strukturiert, so dass jedem Pixel mindestens eine Pixelgegenelektrode zugeordnet werden kann.

Es ist bekannt, dass organische, elektromagnetische Strahlung emittierende Schichten oftmals aus einer Vielzahl von Teilschichten bestehen, die auch beim erfindungsgemäßen Verfahren als organische Schicht abgeschieden werden können. Lediglich beispielhaft seien nachfolgend einige dieser Teilschichten, die solch eine Schicht umfassen kann, mit ihren englischsprachigen Fachbegriffen und zugehörigen Kürzeln in Klammern, ohne Anspruch auf Vollständigkeit, aufgezählt: Lochinjektionsschicht (Hole Injection Layer, HIL), Lochleitungsschicht (Hole Transport Layer, HTL), Elektronenblockerschicht (Electron Blocking Layer, EBL), Emissionsschicht (Emission Layer, EML), Lochblockerschicht (Hole Blocking Layer, HBL), Elektronenleitungsschicht (Electron Transport Layer, ETL).

Anschließend wird noch mindestens eine transparente Deckschicht oberhalb der mindestens einen, elektromagnetische Strahlung emittierenden Schicht aufgetragen. Die transparente Deckschicht kann beispielsweise als Glas oder Kunststofffolie ausgebildet werden. Als Zwischenprodukt entsteht auf diese Weise ein Verbund, mindestens umfassend den SOI-Wafer, die elektromagnetische Strahlung emittierende Schicht und die transparente Deckschicht. Zwischen dem SOI-Wafer, der elektromagnetische Strahlung emittierenden Schicht und der transparenten Deckschicht können aber auch noch weitere Schichten wie beispielsweise Barriereschichten oder Haftvermittlerschichten abgeschieden sein.

Erfindungsgemäß wird das Silizium-Substrat des SOI-Wafers vom Verbund entfernt, wodurch ein Restverbund entsteht. Das Silizium-Substrat kann beispielsweise mit mechanischen Mitteln vom Verbund abgeschliffen und/oder mittels chemischer Substanzen vom Verbund entfernt werden. Das Silizium-Substrat, welches vorwiegend wegen der mechanischen Stabilität am SOI-Wafer vorhanden war, ist für die mechanische Stabilität des Restverbundes eines erfindungsgemäßen Displays nicht erforderlich, weil die Deckschicht, welche beispielsweise als Glas oder als Kunststofffolie ausgebildet sein kann, eine hinreichende mechanische Stabilität des Restverbundes ohne Silizium-Substrat gewährleistet.

Das Entfernen des Silizium-Substrates vom Verbund bewirkt außerdem, dass der Restverbund ohne Silizium-Substrat semitransparent wird. Das bedeutet, dass zumindest in den Bereichen des Restverbundes, in denen keine Transistoren bzw. keine elektrischen Schaltungen und keine elektrisch leitfähige Verbindung ausgebildet ist, Licht, welches von einem menschlichen Auge erfassbar ist, von beiden Seiten durch den Restverbund hindurchstrahlen kann, was vor dem Entfernen des Silizium-Substrates durch das Silizium-Substrat verhindert wurde.

Nach dem Entfernen des Silizium-Substrates vom SOI-Wafer kann bei einem Ausführungsbeispiel eine nicht transparente Schicht auf der Rückseite des Rest-SOI-Wafers abgeschieden und strukturiert werden, um beispielsweise rückseitig ankommende und störend wirkende elektromagnetische Strahlung auf die Pixelschaltung abzuschirmen. In Bereichen außerhalb der Pixelschaltung bleibt hierbei die Transparenz erhalten.

Nachdem das Silizium-Substrat vom Verbund entfernt wurde wird erfindungsgemäß ein Verdrahtungsträger an der Vorderseite oder an der Rückseite des Restverbundes befestigt. Ein Verdrahtungsträger kann beispielsweise als Leiterplatte ausgebildet sein.

Wird der Verdrahtungsträger an der Vorderseite des Restverbundes befestigt, von der im Pixelbereich elektromagnetische Strahlung emittiert wird, so weist der Verdrahtungsträger zumindest im Pixelbereich eine Ausnehmung auf.

Erfindungsgemäß werden elektrisch leitfähige Verbindungen zwischen dem Kontaktbereich des ehemaligen SOl-Wafers, der nun nur noch teilweise Bestandteil des Restverbundes ist, und des Verdrahtungsträgers von der Rückseite des SOI-Wafers her ausgebildet. Dies ist jetzt möglich, weil zuvor das Silizium-Substrat entfernt wurde, wodurch nun innerhalb des Kontaktbereiches mit bekannten Verfahrensschritten Kontaktelemente bzw. elektrisch leitfähige Elemente, vornehmlich aus der untersten Verdrahtungsebene, rückseitig freigelegt werden können. Ist der Verdrahtungsträger an der Vorderseite des Restverbundes befestigt, können elektrisch leitfähige Verbindungen zwischen dem Kontaktbereich und dem Verdrahtungsträger beispielsweise als Drahtbond ausgebildet werden. Ist der Verdrahtungsträger an der Rückseite des Restverbundes befestigt, können elektrisch leitfähige Verbindungen zwischen dem Kontaktbereich und dem Verdrahtungsträger beispielsweise als Bump-Bond oder anisotrop leitfähige Klebestelle ausgebildet werden.

Die Erfindung wird nachfolgend an Ausführungsbeispielen näher beschrieben. Die Fig. zeigen:
- Fig. 1: eine schematische Schnittdarstellung eines für einen Displayaufbau geeigneten SOI-Wafer,
- Fig. 2: eine schematische Schnittdarstellung eines SOI-Wafers, auf welchem eine elektrische Strahlung emittierende Schicht abgeschieden und eine Deckschicht aufgetragen sind,
- Fig. 3: eine schematische Schnittdarstellung des Verbundes aus Fig. 2, von welchem das Silizium-Substrat entfernt ist,
- Fig. 4: eine schematische Schnittdarstellung des Restverbundes aus Fig. 3, an welchem elektrisch leitfähige Elemente freigelegt sind,
- Fig. 5: eine schematische Schnittdarstellung des Restverbundes aus Fig. 4, an welchem vorderseitig ein Verdrahtungsträger befestigt ist,
- Fig. 6: eine schematische Schnittdarstellung des Restverbundes aus Fig. 4, an welchem rückseitig ein Verdrahtungsträger befestigt ist,
- Fig. 7: eine rückseitige schematische Darstellung eines Restverbundes, an welchem vorderseitig ein Verdrahtungsträger befestigt ist.

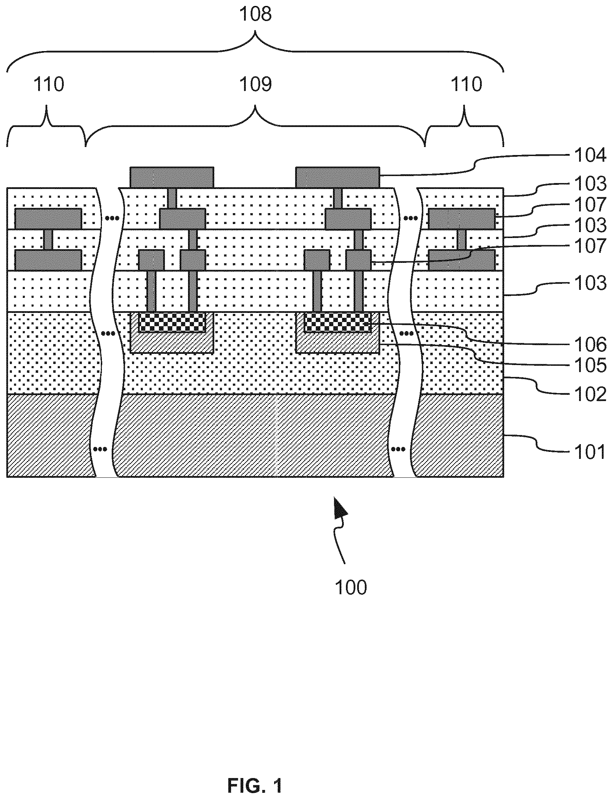

Ein aus dem Stand der Technik bekannter für einen Displayaufbau geeigneter SOl-Wafer 100 ist in Fig. 1 schematisch als Schnitt dargestellt. Der SOI-Wafer 100 umfasst der Reihenfolge nach betrachtet zunächst ein rückseitiges Silizium-Substrat 101, eine transparente Schicht 102 aus einem elektrisch nicht leitenden Material, sowie mehrere transparente Siliziumoxidschichten 103, an deren Oberfläche als Pixelelektroden fungierende Kontakte 104 ausgebildet sind. Innerhalb der Schicht 102 aus elektrisch nicht leitendem Material ist eine Vielzahl von siliziumbasierten Aktivgebieten 105 eingelassen, innerhalb denen elektrische Schaltungen 106 zum Ansteuern von Pixelzellen ausgebildet sind. Innerhalb der Siliziumoxidschichten 103 sind ferner elektrisch leitfähige Elemente 107 ausgebildet, welche sich beispielsweise zwischen Anschlüssen der Schaltungen 106 und/oder von den Anschlüssen der Schaltungen 106 zu den Kontakten 104 hin erstrecken.

Der in Fig. 1 dargestellte Aufbau eines SOI-Wafers ist lediglich beispielhaft. Alternativ kann ein aus dem Stand der Technik bekannter SOl-Wafer auch einen anderen Aufbau aufweisen. So können Aktivgebiete eines SOI-Wafers beispielsweise nicht innerhalb der Schicht 102 sondern auf der Schicht 102 ausgebildet sein. Es sei somit angemerkt, dass alle aus dem Stand der Technik bekannten SOI-Wafer, die für den Aufbau eines Displays geeignet sind auch für das erfindungsgemäße Verfahren und für den Aufbau eines erfindungsgemäßen Displays verwendet werden können.

Der SOI-Wafer 100 ist unterteilt in einen Pixelbereich 109 und einen Kontaktbereich 110. Im Ausführungsbeispiel von Fig. 1 umschließt der Kontaktbereich 110 den Pixelbereich 109 vollständig. Der Übersichtlichkeit wegen ist in den Schnittdarstellungen der Fig. 1 bis 6 nur ein Auszug aus dem Pixelbereich eines SOI-Wafers 100 dargestellt, welcher lediglich zwei siliziumbasierte Aktivgebiete 105 umfasst. Bei einem vollständigen Pixelbereich können hingegen mehrere tausend solcher siliziumbasierten Aktivgebiete 105 nebeneinander angeordnet sein.

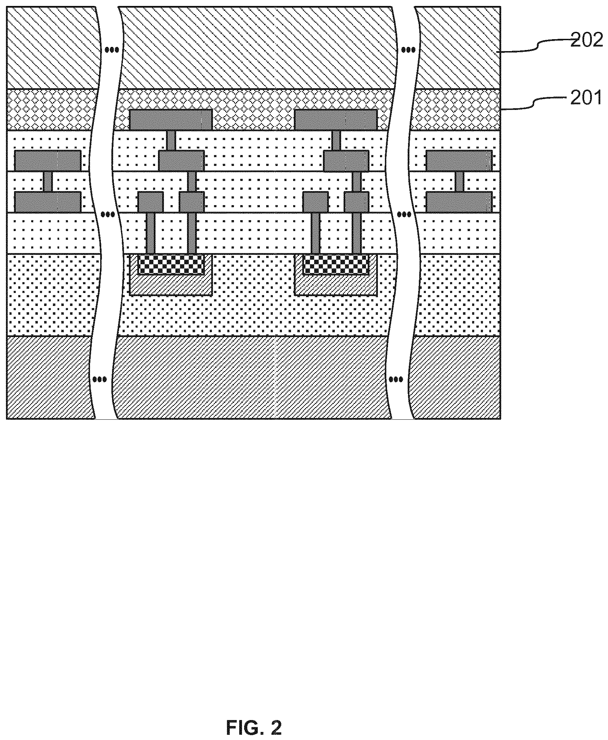

In Fig. 2 ist schematisch im Schnitt dargestellt, dass erfindungsgemäß auf einen SOI-Wafer zunächst mit bekannten Verfahrensschritten eine transparente, elektromagnetische Strahlung emittierende Schicht 201 abgeschieden und anschließend eine transparente Deckschicht 202, welche im Ausführungsbeispiel aus Glas besteht, aufgetragen werden, wodurch ein Verbund bestehend aus SOI-Wafer 100, Schicht 201 und Deckschicht 202 entsteht. Die elektromagnetische Strahlung emittierende Schicht 201 ist im Ausführungsbeispiel als organische Schicht ausgebildet und besteht aus einer Vielzahl von bekannten Teilschichten, wie es zuvor schon einmal beschrieben wurde. Ferner umfasst die Schicht 201 als oberen Abschluss eine Teilschicht aus einem elektrisch leitfähigen Material, wobei die Teilschicht aus dem elektrisch leitfähigen Material entsprechend der Pixelanordnung des entstehenden Displays strukturiert ist und als Pixelgegenelektrode fungiert.

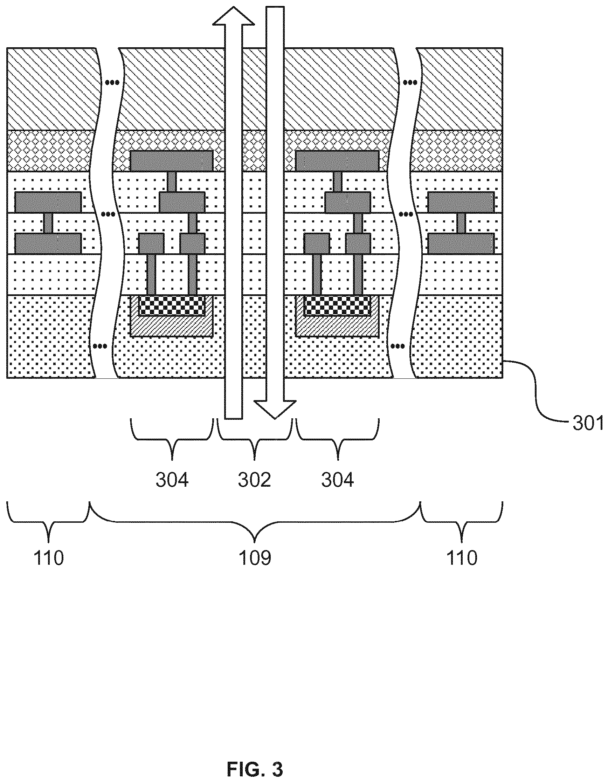

Erfindungsgemäß wird nach dem Herstellen des Verbundes aus SOI-Wafer 100, Schicht 201 und Deckschicht 202 das Silizium-Substrat 101 des ursprünglichen SOI-Wafers 100 vom Verbund entfernt. Dadurch entsteht ein Restverbund 301, welcher in Fig. 3 schematisch als Schnitt dargestellt ist und welcher semitransparent ist. Das bedeutet, der Restverbund 301 ist zumindest innerhalb des Pixelbereiches 109 in den Teilbereichen 302, in denen keine Schaltungselemente und keine elektrisch leitfähigen Elemente ausgebildet sind, von beiden Seiten her transparent bezüglich Licht, welches mit einem menschlichen Auge erfassbar ist, wie es mit den beiden Pfeilen in Fig. 3 schematisch dargestellt ist. Ferner weist der Restverbund 301 aber auch weiterhin Teilbereiche auf, wie beispielsweise die Kontaktbereiche 110 und die Teilbereiche 303 des Pixelbereichs 109, innerhalb denen Schaltungselemente und/oder elektrisch leitfähige Elemente ausgebildet sind und welche somit eine geringere Transparenz gegenüber den Teilbereichen 302 aufweisen.

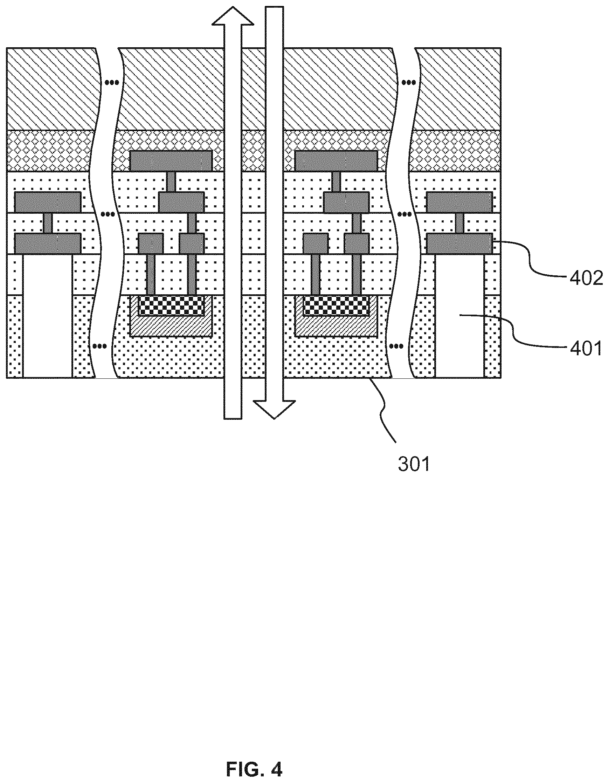

Neben der entstehenden Semitransparenz des Restverbundes 301 geht mit dem Entfernen des Silizium-Substrates 100 vom Verbund noch ein weiterer Vorteil einher. Jetzt ist es möglich am Restverbund 301 rückseitig mit bekannten Verfahrensschritten Vertiefungen 401 einzubringen, welche innerhalb des Kontaktbereiches 110 elektrisch leitfähige Elemente 402 der untersten Verdrahtungsebene freilegen, wie es in Fig. 4 schematisch als Schnitt dargestellt ist.

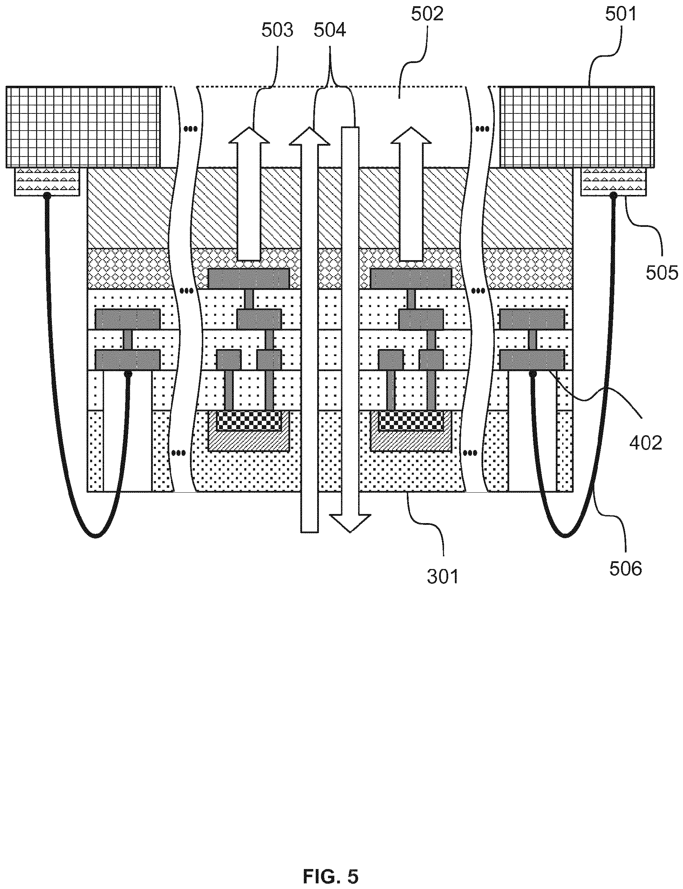

In Fig. 5 ist in einem Schnitt schematisch dargestellt, wie ein Verdrahtungsträger 501 an der Vorderseite des Restverbundes 301 befestigt ist. Der Verdrahtungsträger 501 weist im Pixelbereich des Restverbundes 301 eine Ausnehmung 502 auf, durch welche elektromagnetische Strahlung 503 der Displaypixel sowie den Restverbund 301 durchdringendes Licht 508 hindurchstrahlen kann. Des Weiteren ist in Fig. 5 aufgezeigt, dass Kontaktelemente 505 eines vorderseitig befestigten Verdrahtungsträgers 501, beispielsweise mittels Drahtbonds 506, mit den rückseitig freigelegten elektrisch leitfähigen Elementen 402 kontaktiert werden können.

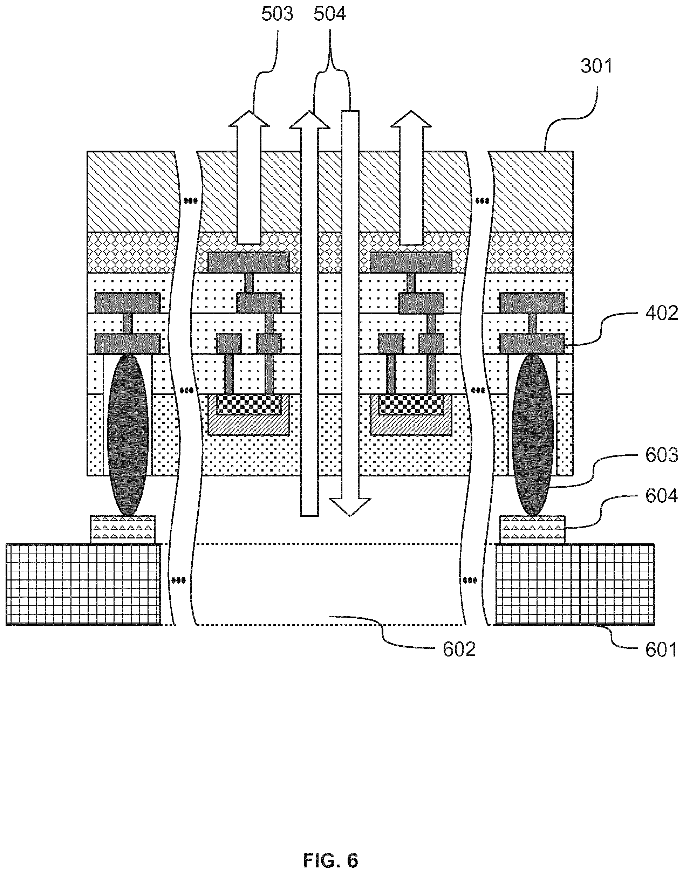

Ein alternativer erfindungsgemäßer Displayaufbau ist in Fig. 6 schematisch als Schnitt dargestellt. An dem aus Fig. 4 bekannten Restverbund 301 wurde bei einer alternativen Vorgehensweise diesmal rückseitig ein Verdrahtungsträger 601 befestigt. Auch der Verdrahtungsträger 601 weist im Pixelbereich des Restverbundes 301 eine Ausnehmung 602 auf. Alternativ kann bei einem rückseitig befestigen Verdrahtungsträger auch keine Ausnehmung im Pixelbereich vorhanden sein, wenn die Eigenschaft der Semitransparenz bei einem Display nicht erforderlich ist. Die rückseitig freigelegten elektrisch leitfähigen Elemente 402 des Restverbundes 301 sind bei dem Ausführungsbeispiel aus Fig. 6 mittels sogenannter Bump-Bonds 603 mit Kontaktelementen 604 des Verdrahtungsträgers 601 elektrisch leitfähig verbunden.

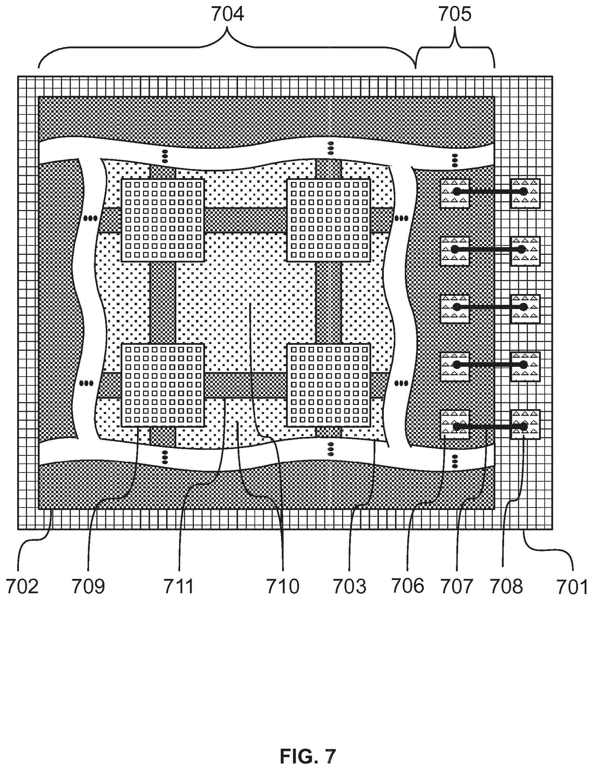

In Fig. 7 ist schließlich noch einmal ein erfindungsgemäßer Displayaufbau schematisch in einer Sicht von der Rückseite dargestellt, bei welchem ein Verdrahtungsträger 701 an der Vorderseite eines Restverbundes 702 befestigt ist, wobei ein Detailausschnitt 703 eines Pixelbereiches 704 des Restverbundes 702 zur besseren Veranschaulichung stark vergrößert dargestellt ist. Der Restverbund 702 weist neben dem Pixelbereich 704 auch einen Kontaktbereich 705 auf. Rückseitig freigelegte, elektrisch leitfähige Elemente 706 innerhalb des Kontaktbereichs 705 sind mittels Drahtbonds 707 mit Kontaktelementen 708 des Verdrahtungsträgers 701 elektrisch leitfähig verbunden.

Im Detailausschnitt 703 sind wegen der besseren Übersichtlichkeit lediglich vier Pixel 709 schematisch dargestellt. Der Detailausschnitt 703 soll noch einmal veranschaulichen, dass es bei einem erfindungsgemäßen Display zwischen den Pixeln 709 eine Vielzahl von Teilbereichen 710 gibt, innerhalb denen keine Schaltungen zum Ansteuern der Pixel 709 und auch keine elektrisch leitfähigen Verbindungen 711 ausgebildet sind, weshalb die Teilbereiche 710 transparent sind. Da die Oberflächenbereiche eines erfindungsgemäßen Displays, innerhalb denen, zum Beispiel Schaltungen oder Elektroden zum Ansteuern von Pixeln 709 oder elektrisch leitfähige Verbindungen 711 ausgebildet sind, eine zumindest geringere oder sogar stark eingeschränkte Transparenz gegenüber den Teilbereichen 710 aufweisen, wird ein erfindungsgemäßes Display als semitransparent bezeichnet.

## Patentansprüche

1. Verfahren zum Herstellen eines semitransparenten Displays, umfassend folgende Verfahrensschritte
a) Bereitstellen eines SOI-Wafers (100), dessen Oberfläche mindestens einen Pixelbereich (109) und mindestens einen neben dem Pixelbereich (109) angeordneten Kontaktbereich (110) aufweist, wobei der SOI-Wafer (100) auf der Rückseite ein Silizium-Substrat (101) und der Reihenfolge nach betrachtet darüber eine transparente Schicht (102) aus einem elektrisch nicht leitenden Material, sowie mehrere transparente Siliziumoxidschichten (103) umfasst , wobei an der Oberfläche der transparenten Siliziumoxidschichten (103) als Pixelelektroden fungierende Kontakte (104) ausgebildet sind, , wobei innerhalb der Schicht (102) aus elektrisch nicht leitendem Material eine Vielzahl von siliziumbasierten Aktivgebieten (105) eingelassen sind, innerhalb denen elektrische Schaltungen (106) zum Ansteuern von Pixelzellen ausgebildet sind und wobei innerhalb der Siliziumoxidschichten (103) elektrisch leitfähige Elemente (107) zum Verbinden von Schaltungen (106) ausgebildet sind;
b) Abscheiden mindestens einer, elektromagnetische Strahlung emittierenden Schicht (201) auf der Vorderseite des SOI-Wafers (100) und auf den als Pixelelektroden fungierenden Kontakten (104);
c) Auftragen mindestens einer transparenten Deckschicht (202) oberhalb der mindestens einen, elektromagnetische Strahlung emittierenden Schicht (201)
d) Befestigen eines Verdrahtungsträgers (501; 601) an dem Verbund, welcher mindestens umfasst, den SOl-Wafer (100), die elektromagnetische Strahlung emittierende Schicht (201) und die transparente Deckschicht (202),
**dadurch gekennzeichnet, dass** vor dem Befestigen des Verdrahtungsträgers (501; 601) an dem Verbund, bestehend aus dem SOI-Wafer (100), der elektromagnetische Strahlung emittierenden Schicht (201) und der transparenten Deckschicht (202), das Silizium-Substrat (101) vom Verbund entfernt wird, wodurch ein Restverbund (301) entsteht, wobei am Restverbund (301) rückseitig Vertiefungen (401) eingebracht werden, welche innerhalb des Kontaktbereichs (110) elektrisch leitfähige Elemente (402) freilegen und wobei elektrisch leitfähige Verbindungen zwischen den im Kontaktbereich (110) des Verbundes (301) freigelegten elektrisch leitfähigen Elementen (402) und des Verdrahtungsträgers (501; 601) ausgebildet werden.

2. Verfahren nach Anspruch 1, **dadurch gekennzeichnet, dass** der Verdrahtungsträger (501) an der Vorderseite des Restverbundes (301) befestigt wird.

3. Verfahren nach Anspruch 2, **dadurch gekennzeichnet, dass** elektrisch leitfähige Verbindungen zwischen dem Kontaktbereich (110) des SOI-Wafers (100) und dem Verdrahtungsträger (501) als Drahtbond (506) ausgebildet werden.

4. Verfahren nach Anspruch 1, **dadurch gekennzeichnet, dass** der Verdrahtungsträger (601) an der Rückseite des Restverbundes (301) befestigt wird.

5. Verfahren nach Anspruch 4, **dadurch gekennzeichnet, dass** elektrisch leitfähige Verbindungen zwischen dem Kontaktbereich (110) des SOl-Wafers und dem Verdrahtungsträger (601) als Bump-Bond (603) oder anisotrop leitfähige Klebestelle ausgebildet werden.

6. Verfahren nach einem der Ansprüche 1 bis 5, **dadurch gekennzeichnet, dass** die mindestens eine, elektromagnetische Strahlung emittierende Schicht (201) als organische Schicht ausgebildet wird.

7. Verfahren nach einem der Ansprüche 1 bis 5, **dadurch gekennzeichnet, dass** die mindestens eine, elektromagnetische Strahlung emittierende Schicht als anorganische Schicht ausgebildet wird.

8. Verfahren nach einem der Ansprüche 1 bis 7, **dadurch gekennzeichnet, dass** das Silizium-Substrat (101) vom Verbund mechanisch abgeschliffen wird und/oder dass das Silizium-Substrat (101) mittels chemischer Substanzen vom Verbund entfernt wird.

9. Verfahren nach einem der vorhergehenden Ansprüche, **dadurch gekennzeichnet, dass** die mindestens eine transparente Deckschicht (202) als Glas oder Kunststofffolie ausgebildet wird.

10. Verfahren nach einem der Ansprüche 1 bis 9, **dadurch gekennzeichnet, dass** Pixelelektroden und Pixelgegenelektroden für die mindestens eine elektromagnetische Strahlung emittierende Schicht innerhalb einer Ebene angeordnet und als Bestandteil des SOI-Wafers ausgebildet werden.

11. Verfahren nach einem der Ansprüche 1 bis 9, **dadurch gekennzeichnet, dass** die als Pixelelektroden fungierenden Kontakte (104) als Bestandteil des SOI-Wafers ausgebildet werden, wobei eine elektrisch leitfähige Schicht oberhalb angrenzend an die mindestens eine elektromagnetische Strahlung emittierende Schicht abgeschieden wird.

12. Verfahren nach Anspruch 11, **dadurch gekennzeichnet, dass** die elektrisch leitfähige Schicht strukturiert wird.

## Claims

1. Method for manufacturing a semi-transparent display, comprising:
a) providing an SOI wafer (100) whose surface comprises at least one pixel region (109) and at least one contact region (110) situated next to the pixel region, wherein the SOI wafer (100) includes, on its rear side, a silicon substrate (101) and above the same, viewed in this order, a transparent layer (102) made from an electrically non-conductive material as well as multiple transparent silicon oxide layers (103), wherein, at the surface of one of the transparent silicon oxide layers (103), contacts (104) serving as pixel electrodes are formed, wherein, in the layer (102) of electrically non-conductive material, a multitude of silicon-based active regions (105) are embedded in which electrical circuits (106) for controlling pixel cells are formed, and wherein, in the silicon oxide layers (103), electrically conductive elements (107) for connecting circuits (106) are formed;
b) depositing at least one electromagnetic radiation emitting layer (201) on the front side of the SOI wafer (100) and on the contacts (104) serving as pixel electrodes;
c) applying at least one transparent cover layer (202) above the at least one electromagnetic radiation emitting layer (201);
d) attaching a wiring carrier (501; 601) to the composite including, at least, the SOI wafer (100), the electromagnetic radiation emitting layer (201) and the transparent cover layer (202),
**characterized in that**, prior to attaching the wiring carrier (501; 601) to the composite, consisting of the SOI wafer (100), the electromagnetic radiation emitting layer (201) and the transparent cover layer (202), the silicon substrate (101) is removed from the composite, thereby creating a remaining composite (301), wherein depressions (401) are introduced on the rear side of the remaining composite, which expose electrically conductive elements (402) within the contact region (110) and wherein electrically conductive connections between the electrically conductive elements (402) that are exposed within the contact region (110) of the composite (301) and the wiring carrier (501; 601) are formed.

2. Method according to claim 1, **characterized in that** the wiring carrier (501) is attached to the front side of the remaining composite (301).

3. Method according to claim 2, **characterized in that** the electrically conductive connections between the contact region (110) of the SOI wafer (100) and the wiring carrier (501) are formed to be a wire bond (506).

4. Method according to claim 1, **characterized in that** the wiring carrier (601) is attached to the rear side of the remaining composite (301).

5. Method according to claim 4, **characterized in that** the electrically conductive connections between the contact region (110) of the SOI wafer and the wiring carrier (601) are formed to be a bump bond (603) or an anisotropically conducting bond.

6. Method according to any one of claims 1 to 5, **characterized in that** the at least one electromagnetic radiation emitting layer (201) is formed to be an organic layer.

7. Method according to any one of claims 1 to 5, **characterized in that** the at least one electromagnetic radiation emitting layer is formed to be an inorganic layer.

8. Method according to any one of claims 1 to 7, **characterized in that** the silicon substrate (101) is mechanically abraded from the composite and/or that the silicon substrate (101) is removed from the composite using chemical substances.

9. Method according to any one of the preceding claims, **characterized in that** the at least one transparent cover layer (202) is formed to be glass or a plastic film.

10. Method according to any one of claims 1 to 9, **characterized in that** pixel electrodes and pixel counter electrodes for the at least one electromagnetic radiation emitting layer are arranged on one level and as a component of the SOI wafer.

11. Method according to any one of claims 1 to 9, **characterized in that** the contacts (104) serving as pixel electrodes are formed as a component of the SOI wafer, wherein an electrically conductive layer is deposited above and adjacent the at least one electromagnetic radiation emitting layer.

12. Method according to claim 11, **characterized in that** the electrically conductive layer is structured.

## Revendications

1. Procédé de fabrication d'un écran semi-transparent, comprenant les étapes suivantes
a) fournir une plaquette SOI (100), dont la surface comprend au moins une région de pixel (109) et au moins une région de contact (110) situé de manière adjacente à la région de pixel (109), la plaquette SOI (100) incluant, sur sa face arrière, un substrat en silicium (101) et, au-dessus de celui-ci, dans cet ordre, une couche transparente (102) constituée d'un matériau électriquement non conducteur, ainsi qu'une pluralité de couches transparentes d'oxyde de silicium (103), des contacts (104) faisant office d'électrodes de pixel étant formés à la surface des couches transparentes d'oxyde de silicium (103), une multitude de régions actives à base de silicium (105) étant noyées dans la couche (102) constituée d'un matériau électriquement non conducteur, à l'intérieur desquelles sont formés des circuits électriques (106) destinés à commander des cellules de pixel, et des éléments électriquement conducteurs (107) destinés à relier les circuits (106) étant formés à l'intérieur des couches d'oxyde de silicium (103) ;
b) déposer au moins une couche (201) émettant un rayonnement électromagnétique sur la face avant de la plaquette SOI (100) et sur les contacts (104) faisant office d'électrodes de pixel ;
c) appliquer au moins une couche de recouvrement transparente (202) au-dessus de ladite au moins une couche (201) émettant un rayonnement électromagnétique
d) fixer un support de câblage (501 ; 601) à l'ensemble comprenant au moins la plaquette SOI (100), la couche (201) émettant un rayonnement électromagnétique et la couche de recouvrement transparente (202),
**caractérisé en ce que**, avant de fixer le support de câblage (501 ; 601) à l'ensemble constitué de la plaquette SOI (100), de la couche (201) émettant un rayonnement électromagnétique et de la couche de recouvrement transparente (202), le substrat en silicium (101) est retiré de l'ensemble, de sorte qu'il en résulte un ensemble résiduel (301), des évidements (401) étant réalisés sur la face arrière de l'ensemble résiduel (301), lesquels mettent à découvert, dans la région de contact (110), des éléments électriquement conducteurs (402), et des liaisons électriquement conductrices étant formées entre les éléments électriquement conducteurs (402) mis à découvert dans la région de contact (110) de l'ensemble (301) et le support de câblage (501 ; 601).

2. Procédé selon la revendication 1, **caractérisé en ce que** le support de câblage (501) est fixé sur la face avant de l'ensemble résiduel (301).

3. Procédé selon la revendication 2, **caractérisé en ce que** les liaisons électriquement conductrices entre la région de contact (110) de la plaquette SOI (100) et le support de câblage (501) sont réalisées sous la forme de liaisons filaires (506).

4. Procédé selon la revendication 1, **caractérisé en ce que** le support de câblage (601) est fixé sur la face arrière de l'ensemble résiduel (301).

5. Procédé selon la revendication 4, **caractérisé en ce que** les liaisons électriquement conductrices entre la région de contact (110) de la plaquette SOI et le support de câblage (601) sont réalisées sous la forme de liaisons par plots (603) ou de joints de collage conducteurs anisotropes.

6. Procédé selon l'une des revendications 1 à 5, **caractérisé en ce que** ladite au moins une couche (201) émettant un rayonnement électromagnétique est réalisée sous la forme d'une couche organique.

7. Procédé selon l'une des revendications 1 à 5, **caractérisé en ce que** ladite au moins une couche émettant un rayonnement électromagnétique est réalisée sous la forme d'une couche inorganique.

8. Procédé selon l'une des revendications 1 à 7, **caractérisé en ce que** le substrat en silicium (101) est retiré de l'ensemble par meulage mécanique et/ou **en ce que** le substrat en silicium (101) est retiré de l'ensemble au moyen de substances chimiques.

9. Procédé selon l'une des revendications précédentes, **caractérisé en ce que** ladite au moins une couche de recouvrement transparente (202) est réalisée sous la forme de verre ou d'un film plastique.

10. Procédé selon l'une des revendications 1 à 9, **caractérisé en ce que** les électrodes de pixel et les contre-électrodes de pixel pour ladite au moins une couche émettant un rayonnement électromagnétique sont disposées dans un même plan et sont réalisées en tant que partie intégrante de la plaquette SOI.

11. Procédé selon l'une des revendications 1 à 9, **caractérisé en ce que** les contacts (104) faisant office d'électrodes de pixel sont réalisés en tant que partie intégrante de la plaquette SOI, une couche électriquement conductrice étant déposée au-dessus et adjacent de ladite au moins une couche émettant un rayonnement électromagnétique.

12. Procédé selon la revendication 11, **caractérisé en ce que** la couche électriquement conductrice est structurée.
